# EUROPEAN PATENT APPLICATION

(11) **EP 4 848 487 A1**
(43) Date of publication of application: **02.12.2026**
(21) Application number: 25767173.5
(22) Date of filing: 14.02.2025
(51) Int. Cl.: H01R 13/02, H01L 21/683

(54) **ELECTRICAL CONNECTION STRUCTURE, LOWER ELECTRODE ASSEMBLY AND PROCESS CHAMBER**

(30) Priority: 05.03.2024 CN 202410251293
(71) Applicant: Beijing NAURA Microelectronics Equipment Co., Ltd., Beijing 100176 (CN)
(72) Inventor: ZHAO, Yuxuan, Beijing 100176 (CN); LIU, Jian, Beijing 100176 (CN)
(74) Representative: Cohausz & Florack
(86) International application number: PCT/CN2025/077332
(87) International publication number: WO 2025/185431

(57) **Abstract**

The present disclosure provides an electrical connection structure, a lower electrode assembly, and a process chamber. The disclosed electrical connection structure is for a wafer carrying apparatus. The electrical connection structure includes an insulating base and a conductive part, where: the conductive part is configured to supply power to the wafer carrying apparatus, the conductive part includes a first rigid conductive member, a deformable conductive member, and a second rigid conductive member that are connected in sequence, the first rigid conductive member and the second rigid conductive member extend through the insulating base, the insulating base has a deformation space, and the deformable conductive member is disposed in the deformation space. The above solution can solve the problem that the wafer carrying apparatus in the related art is prone to damage.

## Description

### TECHNICAL FIELD

The present disclosure relates to the technical field of semiconductor equipment, and particularly relates to an electrical connection structure, a lower electrode assembly, and a process chamber.

### BACKGROUND

A wafer carrying apparatus (for example, an electrostatic chuck (ESC)) may be an apparatus that uses electrostatic attraction to secure and support a wafer during a semiconductor manufacturing process, thereby preventing the wafer from moving or becoming misaligned during processing, or may be an apparatus that controls the surface temperature of the wafer or provides a bias voltage to the wafer.

The wafer carrying apparatus mainly includes a base and a functional layer (typically a ceramic layer). The base provides support for the functional layer. The functional layer is provided with an electrostatic attraction electrode, a bias electrode, a heating electrode, or the like. The electrostatic attraction electrode is configured to apply electrostatic attraction to a wafer placed above the functional layer. The heating electrode is configured to increase the temperature of the wafer, thereby increasing the process reaction rate. In addition, by providing a plurality of heating electrodes, the temperatures of different regions on the wafer surface can be adjusted independently, thereby improving the temperature uniformity of the wafer carrying apparatus and further improving process uniformity. The bias electrode can provide a bias voltage to the wafer.

The electrostatic attraction electrode, the bias electrode, the heating electrode, or the like of the wafer carrying apparatus need to be electrically connected to the power supply at the machine end. Therefore, a conductive structure needs to be provided at the bottom end of the functional layer to introduce current from the machine end into the electrostatic attraction electrode, the bias electrode, the heating electrode, or the like. In the related art, the conductive structure generally uses a metal rod (for example, a copper rod). One end of the metal rod is welded to a connection terminal of the functional layer, and the other end extends through the base for electrical connection to the machine end. However, in some processes (for example, etching), the needed process temperature is relatively high, for example, reaching about 350°C. Because the coefficient of thermal expansion of the metal is relatively large, a relatively large expansion force is generated in the metal rod, which is then directly applied to the functional layer, thereby easily causing damage to the wafer carrying apparatus due to the functional layer being damaged by the expansion force.

### SUMMARY

The present disclosure provides an electrical connection structure, a lower electrode assembly, and a process chamber, to mitigate the problem that the wafer carrying apparatus in the related art is prone to damage.

To solve the above technical problem, the present disclosure is implemented as follows:
In a first aspect, the present disclosure provides an electrical connection structure for a wafer carrying apparatus. The electrical connection structure includes an insulating base and a conductive part, where:
The conductive part is configured to supply power to the wafer carrying apparatus. The conductive part includes a first rigid conductive member, a deformable conductive member, and a second rigid conductive member that are connected in sequence. The first rigid conductive member and the second rigid conductive member extend through the insulating base. The insulating base has a deformation space, and the deformable conductive member is disposed within the deformation space.

In a second aspect, the present disclosure further provides a lower electrode assembly. The disclosed lower electrode assembly includes: a wafer carrying apparatus and the electrical connection structure according to the first aspect.

The wafer carrying apparatus includes a base and a functional layer stacked and connected to the base. An electrode is provided in the functional layer, and a connection terminal extends from the electrode. The base has an accommodation space. At least part of the electrical connection structure is located in the accommodation space, and the second rigid conductive member is electrically connected to the connection terminal.

In a third aspect, the present disclosure further provides a process chamber. The disclosed process chamber includes a chamber body and the lower electrode assembly disposed in the chamber body, where the lower electrode assembly is the lower electrode assembly according to the second aspect.

The technical solutions employed in the present disclosure can achieve the following technical effects:
In the electrical connection structure disclosed in the embodiments of the present disclosure, a first rigid conductive member, a deformable conductive member, and a second rigid conductive member that are connected in sequence are provided, and a deformation space is formed in the insulating base, such that the deformable conductive member is disposed in the deformation space, thereby enabling the machine end to be electrically connected to the electrode on the wafer carrying apparatus sequentially through the first rigid conductive member, the deformable conductive member, and the second rigid conductive member, thereby supplying power to the wafer carrying apparatus. Because the first rigid conductive member and the second rigid conductive member are connected by the deformable conductive member, when the ambient temperature in the process chamber is at a relatively high temperature and the second rigid conductive member expands due to heating, the expansion force of the second rigid conductive member acts on the deformable conductive member, thereby reducing the expansion force acting on the wafer carrying apparatus through deformation of the deformable conductive member, thereby preventing damage to the wafer carrying apparatus.

In addition, when the first rigid conductive member is plug-fitted with the machine end to achieve an electrical connection, if the insertion force is relatively large, deformation of the deformable conductive member can buffer the force acting on the wafer carrying apparatus, thereby preventing the wafer carrying apparatus from being damaged due to an excessive insertion force between the first rigid conductive member and the machine end.

### BRIEF DESCRIPTION OF THE DRAWINGS

FIG. 1 is a schematic diagram of the engagement between the electrical connection structure and the connection terminal of the functional layer disclosed in the embodiments of the present disclosure.
FIG. 2 is a perspective view of the electrical connection structure disclosed in the embodiments of the present disclosure.
FIG. 3 is a schematic structural diagram of the electrical connection structure disclosed in the embodiments of the present disclosure.
FIG. 4 is a schematic structural diagram of the second base disclosed in the embodiments of the present disclosure.
FIG. 5 is a perspective view of the engagement between the second base and the first base disclosed in the embodiments of the present disclosure.
FIG. 6 is a schematic diagram of the engagement between the second base and the first base disclosed in the embodiments of the present disclosure.
FIG. 7 is a schematic diagram of the connection between the first rigid conductive member and the flexible conductive member disclosed in the embodiments of the present disclosure.
FIG. 8 is a schematic diagram of the connection among the first rigid conductive member, the second rigid conductive member, and the flexible conductive member disclosed in the embodiments of the present disclosure.
FIG. 9 is a schematic diagram of the engagement between another electrical connection structure and the connection terminal of the functional layer disclosed in the embodiments of the present disclosure.

### Description of Reference Numerals:

100-insulating base,
101-deformation space, 110-first base, 111-mounting groove, 112-first through hole, 113-first limiting part, 120-second base, 121-partition, 121a-subspace, 122-mounting part, 123-connection part, 130-third base, 131-second through hole.
210-first rigid conductive member, 211-welding groove, 220-second rigid conductive member, 230-flexible conductive member, 240-conductive spring.
300-thermal insulation member.
400-insulating thermal insulation layer.
500-functional layer, 510-connection terminal.
600-base.
710-spring washer, 720-flat washer.

### DETAILED DESCRIPTION OF THE EMBODIMENTS

To make the objectives, technical solutions, and advantages of the present disclosure clearer, the technical solutions of the present disclosure will be described clearly and completely below with reference to the specific embodiments of the present disclosure and the accompanying drawings. Apparently, the described embodiments are only some of the embodiments of the present disclosure, rather than all of the embodiments. All other embodiments obtained by a person of ordinary skill in the art based on the embodiments of the present disclosure without making any inventive effort fall within the scope of the present disclosure.

The technical solutions disclosed in the various embodiments of the present disclosure are described in detail below with reference to the accompanying drawings.

During processing of a wafer by semiconductor process equipment (for example, a Plasma Etching (ETCH) process, a Physical Vapor Deposition (PVD) process, a Chemical Vapor Deposition (CVD) process, or the like), the wafer generally needs to be transferred into a process chamber and placed on a wafer carrying apparatus. The wafer carrying apparatus can support and secure the wafer to prevent the wafer from moving or becoming misaligned during the process. The wafer carrying apparatus can also control the surface temperature of the wafer placed thereon and provide a bias voltage to the wafer.

The wafer carrying apparatus generally attracts a wafer onto the wafer carrying apparatus by using an electrostatic attraction electrode. The wafer carrying apparatus generally heats the wafer by using a heating electrode. The wafer carrying apparatus can provide a bias voltage to the wafer by using a bias electrode. However, the electrostatic attraction electrode, the heating electrode, the bias electrode, or the like of the wafer carrying apparatus all need to be supplied with power from the machine end. The electrostatic attraction electrode, the heating electrode, the bias electrode, or the like may each be led out to form a connection terminal. The electrical connection structure disclosed in the embodiments of the present disclosure is provided at the wafer carrying apparatus and is configured to electrically connect the connection terminal and the machine end, so as to introduce current from the machine end into the electrostatic attraction electrode, the heating electrode, the bias electrode, or the like of the wafer carrying apparatus.

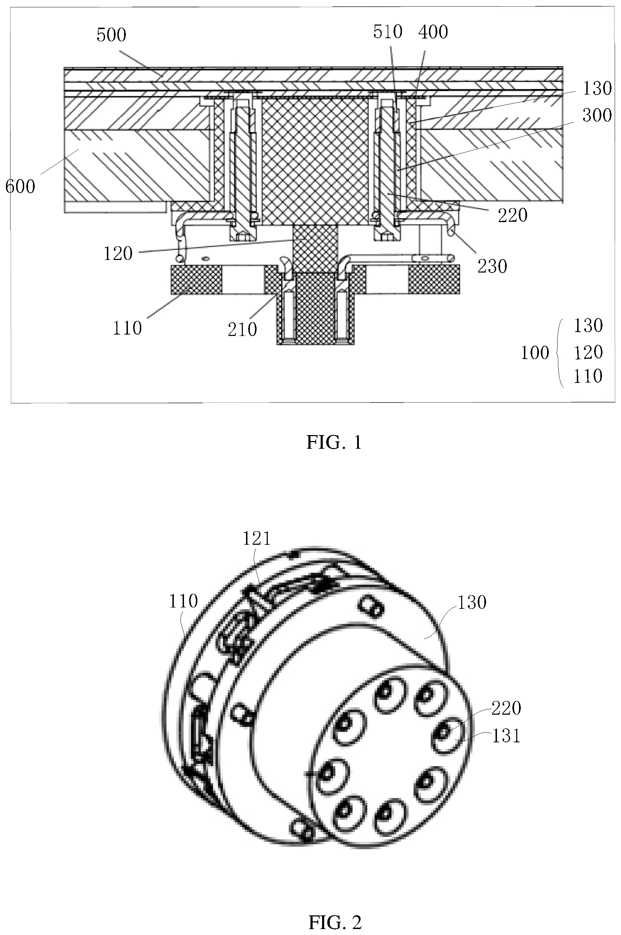

Referring to FIGS. 1 to 3, the embodiments of the present disclosure provide an electrical connection structure for a wafer carrying apparatus. The disclosed electrical connection structure includes an insulating base 100 and a conductive part.

The conductive part is configured to supply power to the wafer carrying apparatus. The disclosed conductive part includes a first rigid conductive member 210, a deformable conductive member, and a second rigid conductive member 220 that are connected in sequence. The first rigid conductive member 210 and the second rigid conductive member 220 extend through the insulating base 100. The insulating base 100 has a deformation space 101. The deformable conductive member is disposed in the deformation space 101 and can deform within the deformation space 101.

Specifically, the first rigid conductive member 210 can be used to be electrically connected to the machine end (i.e., the power supply end), and the second rigid conductive member 220 can be used to be electrically connected to the electrode on the wafer carrying apparatus, thereby supplying power to the wafer carrying apparatus.

In the electrical connection structure disclosed in the embodiments of the present disclosure, a first rigid conductive member 210, a deformable conductive member, and a second rigid conductive member 220 that are connected in sequence are provided, and a deformation space 101 is formed in the insulating base 100, such that the deformable conductive member is disposed in the deformation space 101, thereby enabling the machine end to be electrically connected to the electrode on the wafer carrying apparatus sequentially through the first rigid conductive member 210, the deformable conductive member, and the second rigid conductive member 220, thereby supplying power to the wafer carrying apparatus. Since the first rigid conductive member 210 and the second rigid conductive member 220 are connected by the deformable conductive member, when the ambient temperature in the process chamber is at a relatively high temperature and the second rigid conductive member 220 expands due to heating, the expansion force of the second rigid conductive member 220 acts on the deformable conductive member, thereby reducing the expansion force acting on the wafer carrying apparatus through deformation of the deformable conductive member, thereby preventing damage to the wafer carrying apparatus.

In addition, when the first rigid conductive member 210 is plug-fitted with the machine end to achieve an electrical connection, if the insertion force is relatively large, deformation of the deformable conductive member can buffer the force acting on the wafer carrying apparatus, thereby preventing the wafer carrying apparatus from being damaged due to an excessive insertion force between the first rigid conductive member 210 and the machine end.

Specifically, the insulating base 100 may be made of a polyimide material. Of course, the insulating base 100 may also be made of other insulating materials, and the embodiments of the present disclosure do not specifically limit the material of the insulating base 100. The first rigid conductive member 210 and the machine end may be electrically connected by using a multi-pin connector.

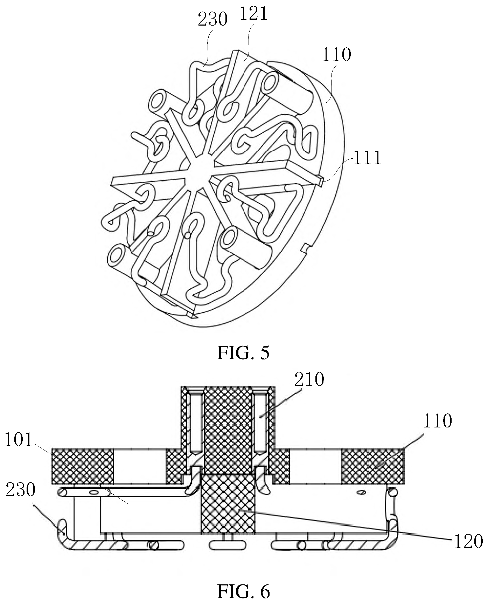

Referring to FIGS. 5 to 8, in some embodiments, the deformable conductive member may include a flexible conductive member 230. The flexible conductive member 230 has a redundant bent section in the deformation space 101. By configuring the deformable conductive member as the flexible conductive member 230, the expansion force acting on the wafer carrying apparatus can be reduced more effectively, and the impact on the wafer carrying apparatus during plug fitting of the first rigid conductive member 210 with the machine end can also be alleviated more effectively.

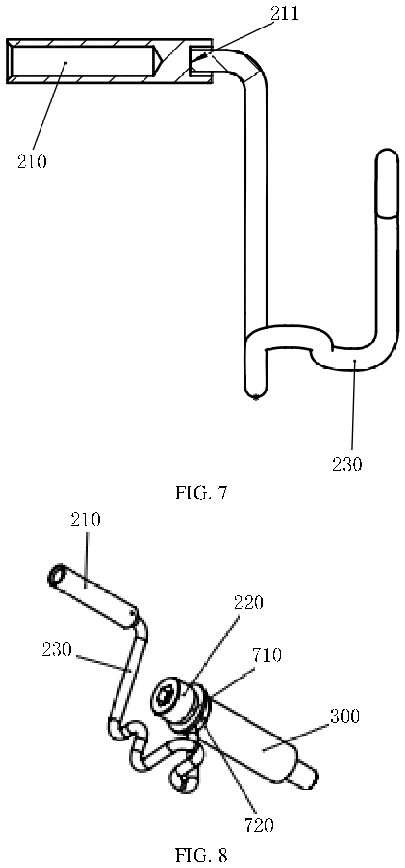

Referring to FIG. 7, in some embodiments, the first rigid conductive member 210 may be provided with a welding groove 211. The flexible conductive member 230 may be soldered in the welding groove 211 by using solder, such that the connection between the first rigid conductive member 210 and the flexible conductive member 230 is more stable. The flexible conductive member 230 being soldered in the welding groove 211 means that one end of the flexible conductive member 230 is soldered in the welding groove 211.

Further, a solder outlet hole communicating with the welding groove 211 may be formed in the side wall of the welding groove 211, thereby facilitating filling of the welding groove 211 with solder and further improving the connection stability between the first rigid conductive member 210 and the flexible conductive member 230.

Referring to FIG. 1, in order to avoid damage to the machine end caused by excessive heat being transferred from the wafer carrying apparatus due to the excessively high temperature of the wafer carrying apparatus, in some embodiments, the electrical connection structure may further include an insulating thermal insulation layer 400. The insulating thermal insulation layer 400 may be connected to the insulating base 100 and may be located at the side of the insulating base 100 that is configured to be connected to the wafer carrying apparatus.

In the electrical connection structure disclosed in the embodiments of the present disclosure, the insulating thermal insulation layer 400 is provided at the side of the insulating base 100 configured to be connected to the wafer carrying apparatus, thereby better preventing excessive heat from the wafer carrying apparatus from being transferred to the machine end, thereby protecting the machine end. In addition, the insulating thermal insulation layer 400 can prevent the insulating base 100 from directly contacting the wafer carrying apparatus, thereby protecting the wafer carrying apparatus.

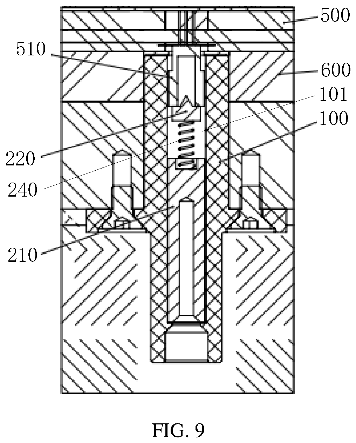

Referring to FIG. 9, in another embodiment, the deformable conductive member may include a conductive spring 240. The second rigid conductive member 220 may contact the wafer carrying apparatus under the elastic force of the conductive spring 240. Specifically, the second rigid conductive member 220 may contact the connection terminal 510 extending from the electrode of the wafer carrying apparatus under the elastic force of the conductive spring 240.

In the electrical connection structure disclosed in the embodiments of the present disclosure, the deformable conductive member is configured as the conductive spring 240, such that the second rigid conductive member 220 can contact the wafer carrying apparatus under the elastic force of the conductive spring 240, thereby reducing the expansion force acting on the wafer carrying apparatus through elastic deformation of the conductive spring 240 and alleviating the impact on the wafer carrying apparatus when the first rigid conductive member 210 is plug-fitted with the machine end.

Referring to FIG. 1, in order to alleviate the problem that excessive heat is transferred to the machine end due to the excessively high temperature of the wafer carrying apparatus, in some embodiments, the electrical connection structure may further include a thermal insulation member 300. The thermal insulation member 300 may be sleeved over the second rigid conductive member 220. In the electrical connection structure disclosed in the embodiments of the present disclosure, by providing the thermal insulation member 300 and sleeving the thermal insulation member 300 over the second rigid conductive member 220, excessive heat from the wafer carrying apparatus can be prevented from being transferred to the machine end to a certain extent. The thermal insulation member 300 may be made of stainless steel, or an alloy having relatively low thermal conductivity, such as Kovar (Kovar alloy).

In some embodiments, the thermal insulation member 300 may be made of a conductive metal. In the embodiments of the present disclosure, by configuring the thermal insulation member 300 to be made of a conductive metal, the electrical conductivity between the second rigid conductive member 220 and the connection terminal 510 extending from the electrode of the wafer carrying apparatus can be improved.

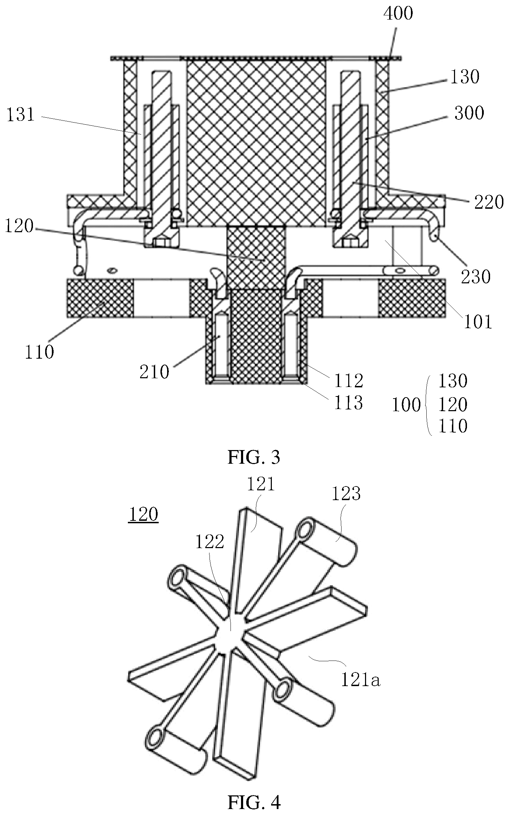

Since the wafer carrying apparatus generally needs to be provided with an electrostatic attraction electrode, a bias electrode, a heating electrode, or the like, a plurality of conductive parts need to be provided. Because the deformable conductive members can deform, in order to prevent a short circuit caused by contact between the deformable conductive members of different conductive parts, in some embodiments, the electrical connection structure may include a plurality of conductive parts. The first rigid conductive members 210 of the plurality of conductive parts may extend through the insulating base 100 at intervals and be located at positions adjacent to one end of the insulating base 100. The second rigid conductive members 220 of the plurality of conductive parts may extend through the insulating base 100 at intervals and be located at positions adjacent to the other end of the insulating base 100. That is, the first rigid conductive members 210 and the second rigid conductive members 220 are arranged sequentially in a direction from one end of the insulating base 100 toward the other end. Referring to FIG. 4, the insulating base 100 may include a plurality of partitions 121. The deformation space 101 may be divided by the partitions 121 into a plurality of subspaces 121a, and the deformable conductive members of the plurality of conductive parts may be correspondingly disposed in the plurality of subspaces 121a.

In the electrical connection structure disclosed in the embodiments of the present disclosure, by providing the partitions 121, the deformation space 101 is divided by the partitions 121 into a plurality of subspaces 121a, such that the deformable conductive members of the plurality of conductive parts can be correspondingly disposed in the plurality of subspaces 121a, thereby preventing a short circuit caused by contact between the deformable conductive members of different conductive parts.

In one embodiment, the insulating base 100 may be an integral structure.

In another embodiment, referring to FIG. 3, the insulating base 100 may include a first base 110, a second base 120, and a third base 130 that are stacked and connected in sequence. The second base 120 has a deformation space 101. The second base 120 may include a plurality of partitions 121. The first rigid conductive member 210 may extend through the first base 110, and the second rigid conductive member 220 may extend through the third base 130.

In the electrical connection structure disclosed in the embodiments of the present disclosure, the insulating base 100 is configured as the first base 110, the second base 120, and the third base 130 that are stacked and connected in sequence, thereby facilitating installation of the first rigid conductive member 210, the second rigid conductive member 220, the deformable conductive member, and the partitions 121.

Specifically, as shown in FIG. 4, one ends of the plurality of partitions 121 may be connected to each other, and the other ends of the plurality of partitions 121 extend radially, so as to divide the deformation space 101 into a plurality of subspaces 121a. For example, the other ends of the plurality of partitions 121 extend in different directions around the connection position of the plurality of partitions 121 as a center, thereby forming the above-mentioned subspace 121a between adjacent partitions 121. In the electrical connection structure disclosed in the embodiments of the present disclosure, by connecting one ends of the plurality of partitions 121 to each other and extending the other ends radially, the plurality of subspaces 121a can be distributed relatively compactly.

In some embodiments, as shown in FIG. 5, the first base 110 may be provided with a mounting groove 111. The profile of the second base 120 in the stacking direction with respect to the first base 110 is adapted to the extending shape of the mounting groove, and the second base 120 may be inserted into the mounting groove 111. In the embodiments in which the second base 120 includes a plurality of partitions 121, the partitions 121 are respectively inserted into the corresponding mounting grooves 111.

In the electrical connection structure disclosed in the embodiments of the present disclosure, by inserting the second base 120 into the mounting groove 111 of the first base 110, the connection between the second base 120 and the first base 110 is made more stable.

Specifically, the second base 120 is bonded to the inner wall of the mounting groove 111, thereby further improving the connection stability between the second base 120 and the first base 110. In the embodiments in which the second base 120 includes a plurality of partitions 121, the bottoms of the partitions 121 are bonded to the inner wall of the mounting groove 111.

Of course, in another embodiment, the first base 110 may not be provided with the mounting groove 111. The second base 120 and the first base 110 may be directly connected by bonding, snap connection, or the like. The embodiments of the present disclosure do not specifically limit the connection manner between the second base 120 and the first base 110.

In some embodiments, the first base 110 may further be provided with a first limiting part 113. The first base 110 may be provided with a plurality of first through holes 112. The plurality of first rigid conductive members 210 may respectively extend through the plurality of first through holes 112. The first limiting part 113 may be provided at the first opening of the first through hole 112 to abut against the first end of the first rigid conductive member 210 in a limiting manner. The plurality of first through holes 112 may correspond one-to-one with the plurality of subspaces 121a, and the second opening of each first through hole 112 may communicate with the corresponding subspace 121a.

In the electrical connection structure disclosed in the embodiments of the present disclosure, by providing the first limiting part 113 at the first opening of the first through hole 112, the first limiting part 113 can abut against the first end of the first rigid conductive member 210 in a limiting manner, thereby improving the installation stability of the first rigid conductive member 210.

Further, as shown in FIG. 4, the second base 120 may further include a mounting part 122. One ends of the plurality of partitions 121 may be connected to the mounting part 122 around the circumferential direction of the mounting part 122. The mounting part 122 may cover part of the area of the second opening of the first through hole 112 so as to abut against the second ends of the plurality of first rigid conductive members 210 in a limiting manner. Specifically, the mounting part 122 may be cylindrical. Of course, the mounting part 122 may also have other shapes, and the embodiments of the present disclosure do not specifically limit the shape of the mounting part 122.

In the electrical connection structure disclosed in the embodiments of the present disclosure, the second base 120 is configured to include the mounting part 122, such that the mounting part 122 provides a mounting foundation for connecting the plurality of partitions 121. The mounting part 122 can further cover part of the area of the second opening of the first through hole 112 so as to abut against the second ends of the plurality of first rigid conductive members 210 in a limiting manner. Thus, the mounting part 122 serves two functions and cooperates with the first limiting part 113 to limit the first rigid conductive members 210 within the first through holes 112, thereby improving the installation stability of the first rigid conductive members 210.

In order to connect the first base 110, the second base 120, and the third base 130, referring to FIG. 4, in some embodiments, the second base 120 may further include connection parts 123. One end, away from the mounting part 122, of at least some of the plurality of partitions 121 may be provided with the connection parts 123. The connection parts 123 may be provided with connection through holes. The electrical connection structure may further include threaded fasteners. The threaded fasteners may sequentially pass through the first base 110, the connection through holes, and the third base 130, so that the first base 110, the second base 120, and the third base 130 are connected.

In the electrical connection structure disclosed in the embodiments of the present disclosure, the connection parts 123 are provided at one ends, away from the mounting part 122, of at least some of the plurality of partitions 121, and the connection through holes are provided in the connection parts 123, such that the threaded fasteners may sequentially pass through the first base 110, the connection through holes, and the third base 130 to connect the first base 110, the second base 120, and the third base 130. By providing the connection parts 123 at one ends of the partitions 121 away from the mounting part 122, the connection parts 123 are located away from the central region of the second base 120, thereby improving the connection stability of the first base 110, the second base 120, and the third base 130 when the plurality of connection parts 123 cooperate.

In some embodiments, the third base 130 may be provided with a plurality of second through holes 131. The plurality of second through holes 131 may correspond one-to-one with the plurality of subspaces 121a. The first opening of each second through hole 131 may communicate with the corresponding subspace 121a. The second rigid conductive member 220 may be a bolt. The head of the bolt may abut against the wall of the first opening of the second through hole in a limiting manner. The shank of the bolt may extend through the second through hole 131 and may be used for threaded connection with the connection terminal 510 of the wafer carrying apparatus.

In the electrical connection structure disclosed in the embodiments of the present disclosure, by providing the third base 130 with the plurality of second through holes 131 and configuring the second rigid conductive member 220 as a bolt, the head of the bolt abuts against the wall of the first opening of the second through hole 131 in a limiting manner, and the shank of the bolt extends through the second through hole 131 and is threadedly connected to the connection terminal 510 of the wafer carrying apparatus, such that the connection structure between the second rigid conductive member 220 and the connection terminal 510 of the wafer carrying apparatus is relatively simple and more stable. In addition, the connection terminal 510 may extend into the second through hole 131 and threadedly engage with the shank of the bolt, so that the third base 130 can enclose the bolt and the connection terminal 510, thereby preventing electrical arcing.

Further, in some embodiments, a spring washer 710, a flat washer 720, or both the spring washer 710 and the flat washer 720 may be disposed between the head of the bolt and the wall of the first opening of the second through hole 131. The spring washer or the flat washer may be made of stainless steel.

In the electrical connection structure disclosed in the embodiments of the present disclosure, by providing the spring washer 710, the flat washer 720, or both the spring washer 710 and the flat washer 720 between the head of the bolt and the wall of the first opening of the second through hole 131, the contact area between the deformable conductive member and the bolt is increased. In addition, when the shank of the bolt is threadedly connected to the connection terminal 510 extending into the second through hole 131 from the second opening of the second through hole 131, the preload of the bolt can be increased, such that the connection between the bolt and the connection terminal 510 is more stable. The spring washer 710 and the flat washer 720 can also provide a certain buffering effect for the rigid connection between the shank of the bolt and the connection terminal 510.

In order to facilitate operation of the bolt, in some embodiments, a clearance hole may be provided at the position of the first base 110 opposite the head of the bolt. The head of the bolt may be exposed through the subspace 121a and the clearance hole, thereby facilitating operation of the bolt.

In some embodiments, the bolt may be silver-plated on its surface, and the connection terminal 510 may be silver-plated or gold-plated on its surface, thereby improving the electrical conductivity between the bolt and the connection terminal 510.

The present disclosure further provides a lower electrode assembly. The disclosed lower electrode assembly includes the wafer carrying apparatus and the electrical connection structure disclosed in the above embodiments. The wafer carrying apparatus includes a base 600 and a functional layer 500 stacked and connected to the base 600. An electrode is provided in the functional layer 500, and a connection terminal 510 extends from the electrode. The base 600 has an accommodation space. At least part of the electrical connection structure is located in the accommodation space, and the second rigid conductive member 220 is electrically connected to the connection terminal 510.

In the lower electrode assembly disclosed in the embodiments of the present disclosure, by providing the electrical connection structure disclosed in the above embodiments, when the second rigid conductive member 220 is electrically connected to the connection terminal 510, the expansion force of the second rigid conductive member 220 generated when the second rigid conductive member 220 expands due to heating acts on the deformable conductive member instead of the functional layer 500, thereby reducing the expansion force acting on the functional layer 500 through deformation of the deformable conductive member and preventing damage to the functional layer 500.

Specifically, the wafer carrying apparatus may include an Electrostatic Chuck (ESC). The Electrostatic Chuck (ESC) may include the base 600 and the functional layer 500. The electrode provided in the functional layer 500 includes at least one of an electrostatic attraction electrode, a bias electrode, or a heating electrode.

It should be noted that the electrostatic attraction electrode may be used to attract the wafer onto the wafer carrying apparatus, the heating electrode may be used to heat the wafer, and the bias electrode may be used to provide a bias voltage to the wafer, thereby securing and heating the wafer and providing a bias voltage to the wafer.

The present disclosure further provides a process chamber. The disclosed process chamber includes a chamber body and the lower electrode assembly disposed in the chamber body, where the lower electrode assembly is the lower electrode assembly disclosed in the above embodiments.

In the process chamber disclosed in the embodiments of the present disclosure, by providing the lower electrode assembly disclosed in the above embodiments, when the second rigid conductive member 220 is electrically connected to the connection terminal 510, the expansion force of the second rigid conductive member 220 generated when the second rigid conductive member 220 expands due to heating acts on the deformable conductive member instead of the functional layer 500, thereby reducing the expansion force acting on the functional layer 500 through deformation of the deformable conductive member and preventing damage to the functional layer 500.

It should be noted that the functional layer 500 described herein may be made of a ceramic material. Of course, the functional layer 500 may also be made of other materials, and the embodiments of the present disclosure do not specifically limit the material of the functional layer 500.

The foregoing embodiments of the present disclosure mainly describe the differences among the respective embodiments. As long as the different optimized features of the respective embodiments are not contradictory, they may be combined to form better embodiments. For the sake of brevity, details are not repeated herein.

The embodiments of the present disclosure have been described above with reference to the accompanying drawings. However, the present disclosure is not limited to the above specific embodiments. The above specific embodiments are merely illustrative rather than limiting. Under the teaching of the present disclosure, a person of ordinary skill in the art may make many modifications without departing from the spirit of the present disclosure and the scope protected by the claims, and all such modifications fall within the scope of the present disclosure.

## Claims

1. An electrical connection structure for a wafer carrying apparatus, comprising an insulating base and a conductive part, wherein:
the conductive part is configured to supply power to the wafer carrying apparatus, the conductive part includes a first rigid conductive member, a deformable conductive member, and a second rigid conductive member that are connected in sequence, the first rigid conductive member and the second rigid conductive member extend through the insulating base, the insulating base has a deformation space, and the deformable conductive member is disposed in the deformation space.

2. The electrical connection structure according to claim 1, wherein the deformable conductive member includes a flexible conductive member, and the flexible conductive member has a redundant bent section in the deformation space.

3. The electrical connection structure according to claim 1, wherein the first rigid conductive member is provided with a welding groove, and the flexible conductive member is soldered in the welding groove by using solder.

4. The electrical connection structure according to claim 3, wherein a solder outlet hole communicating with the welding groove is provided in a side wall of the welding groove.

5. The electrical connection structure according to claim 1, wherein the electrical connection structure further includes an insulating thermal insulation layer, the insulating thermal insulation layer is connected to the insulating base and is located at a side of the insulating base configured to be connected to the wafer carrying apparatus.

6. The electrical connection structure according to claim 1, wherein the deformable conductive member includes a conductive spring, and the second rigid conductive member contacts the wafer carrying apparatus under an elastic force of the conductive spring.

7. The electrical connection structure according to claim 1, wherein the electrical connection structure further includes a thermal insulation member, and the thermal insulation member is sleeved over the second rigid conductive member.

8. The electrical connection structure according to any one of claims 1 to 7, wherein the electrical connection structure includes a plurality of conductive parts, first rigid conductive members of the plurality of conductive parts extend through the insulating base at intervals; second rigid conductive members of the plurality of conductive parts extend through the insulating base at intervals; the first rigid conductive members and the second rigid conductive members are sequentially arranged in a direction from one end of the insulating base toward another end of the insulating base; and the insulating base includes a plurality of partitions, the deformation space is divided by the partitions into a plurality of subspaces, and the deformable conductive members of the plurality of conductive parts are correspondingly disposed in the plurality of subspaces.

9. The electrical connection structure according to claim 8, wherein the insulating base includes a first base, a second base, and a third base that are stacked and connected in sequence, the second base includes the plurality of partitions, the first rigid conductive member extends through the first base, and the second rigid conductive member extends through the third base.

10. The electrical connection structure according to claim 9, wherein one ends of the plurality of partitions are connected to each other, another ends of the plurality of partitions extend radially, so as to divide the deformation space into the plurality of subspaces.

11. The electrical connection structure according to claim 9, wherein the first base is provided with a mounting groove, a profile of the second base in a stacking direction with respect to the first base is adapted to an extending shape of the mounting groove, and the second base is inserted into the mounting groove.

12. The electrical connection structure according to claim 11, wherein the second base is bonded to an inner wall of the mounting groove.

13. The electrical connection structure according to claim 9, wherein the first base is further provided with a first limiting part, the first base is provided with a plurality of first through holes, the plurality of first rigid conductive members respectively extend through the plurality of first through holes, the first limiting part is provided at a first opening of each first through hole so as to abut against a first end of the first rigid conductive member in a limiting manner, the plurality of first through holes correspond one-to-one with the plurality of subspaces, and a second opening of each first through hole communicates with the corresponding subspace.

14. The electrical connection structure according to claim 13, wherein the second base further includes a mounting part, one ends of the plurality of partitions are connected to the mounting part around a circumferential direction of the mounting part, and the mounting part covers part of an area of the second opening of the first through hole so as to abut against second ends of the plurality of first rigid conductive members in a limiting manner.

15. The electrical connection structure according to claim 14, wherein the second base further includes a connection part, one end, away from the mounting part, of at least some of the plurality of partitions is provided with the connection part, and the connection part is provided with a connection through hole;
the electrical connection structure further includes a threaded fastener, the threaded fastener sequentially passes through the first base, the connection through hole, and the third base so as to connect the first base, the second base, and the third base.

16. The electrical connection structure according to claim 9, wherein the third base is provided with a plurality of second through holes, the plurality of second through holes correspond to the plurality of subspaces, a first opening of each second through hole communicates with the corresponding subspace, the second rigid conductive member is a bolt, a head of the bolt abuts against a wall of the first opening of the second through hole in a limiting manner, a shank of the bolt extends through the second through hole, and the shank is configured to be threadedly connected to a connection terminal of the wafer carrying apparatus.

17. The electrical connection structure according to claim 16, wherein a spring washer and/or a flat washer is connected between the head and a wall of the first opening of the second through hole.

18. The electrical connection structure according to claim 16, wherein a clearance hole is provided at a position of the first base opposite the head, and the head is exposed through the subspace and the clearance hole.

19. A lower electrode assembly, comprising: a wafer carrying apparatus and the electrical connection structure according to any one of claims 1 to 18;
wherein the wafer carrying apparatus includes a base and a functional layer stacked and connected to the base, an electrode is provided in the functional layer, a connection terminal extends from the electrode, the base has an accommodation space, at least part of the electrical connection structure is located in the accommodation space, and the second rigid conductive member is electrically connected to the connection terminal.

20. The lower electrode assembly according to claim 19, wherein the wafer carrying apparatus includes an electrostatic chuck, the electrostatic chuck includes the base and the functional layer, and the electrode provided in the functional layer includes at least one of an electrostatic attraction electrode, a bias electrode, or a heating electrode.

21. A process chamber, comprising: a chamber body and a lower electrode assembly disposed in the chamber body, wherein the lower electrode assembly is the lower electrode assembly according to claim 19 or 20.
